# EUROPÄISCHE PATENTANMELDUNG

(11) **EP 1 130 640 A2**
(43) Veröffentlichungstag der Anmeldung: **05.09.2001**
(21) Anmeldenummer: 01101486.7
(22) Anmeldetag: 24.01.2001
(51) Int. Cl.: H01L 21/8242, H01L 21/316

(54) **Verfahren zur Erhöhung der Kapazität in einem DRAM Grabenkondensator**

(30) Priorität: 29.02.2000 DE 10010821
(71) Anmelder: Infineon Technologies AG, 81669 München (DE)
(72) Erfinder: Ruf, Alexander, Dr., 01127 Dresden (DE); Kegel, Wilhelm, 01465 Langenbrück (DE); Karcher, Wolfram, 01474 Weissig (DE); Schrems, Martin, 01465 Langenbrück (DE)
(74) Vertreter: Wilhelm, Jürgen, Dipl.-Phys.

(57) **Zusammenfassung**

Beim erfindungsgemäßen Verfahren wird im Speichergraben (3) eine erste Schicht Siliziumoxid (4) und darüber eine Schicht Silizium (5) mittels chemical vapor deposition abgeschieden. Über der Schicht Silizium (5) wird eine Schicht oxidierbares Metall (6) abgeschieden. Anschließend werden die Schicht Silizium (5) und die Schicht oxidierbares Metall (6) zu einer Schicht Siliziumoxid und Metalloxid (7) oxidiert.

## Beschreibung

Die Erfindung betrifft ein Verfahren zur Erhöhung der Kapazität in einem Speichergraben und einen Grabenkondensator mit erhöhter Kapazität.

Die Erfindung ist in Speicherschaltungen, wie zum Beispiel DRAM (Dynamik Random Access Memory)- und anderen Halbleiterschaltungen verwendbar.

Bei Graben (Trench)-DRAM Speicherbausteinen beruht die Speicherung von Ladung in einem Kondensator als Speicherelement, welcher topfartig in die Tiefe ausgebildet ist. Dies bringt nicht nur eine Verringerung der Zellenfläche, sondern auch gleichzeitig eine Verringerung der Wahrscheinlichkeit, dass Alphateilchen die Zelle treffen, mit sich. Ein derartiger topfartiger Kondensator wird in einem Trench (Graben) gebildet und auch als Grabenkondensator oder Trenchkondensator bezeichnet. Der Speicher der Trenchzelle weist einen Trench auf, der eine bestimmte Menge Ladung für eine bestimmte Zeitdauer gespeichert halten muss.

Es ist zur Erhaltung und Steigerung der internationalen Wettbewerbsfähigkeit notwendig, die Kosten, die zur Realisierung einer bestimmten elektronischen Funktion aufzuwenden sind, ständig zu senken, um die Produktivität zu steigern. Der Garant für die Produktivitätssteigerung in den letzten Jahren war und ist dabei die CMOS-Technologie bzw. die DRAMTechnologie. Die Trench-DRAM-Technologie verdankt ihre herausragende Stellung vor allem dem geringen Platzbedarf der Trenchkondensatoren selbst sowie der Möglichkeit, die Trenchkondensatoren in einer integrierten Schaltung mit höchster Packungsdichte anzuordnen.

Bei der ständig fortschreitendenden Verringerung der Strukturen nimmt auch der Durchmesser des Trenchs und damit seine Oberfläche ab, so dass bei konventioneller Technik weniger Ladung gespeichert werden kann.

Aus dem Stand der Technik US 5,876,788 ist ein Verfahren zur Herstellung eines Dielektrikums für die DRAM-Zellen bekannt. Dabei wird als Dielektrikum zur Erhöhung der Speicherkapazität Si3N4 aufgrund seiner höheren Dielektrizitätskonstante verwendet. Der Einsatz dieses Dielektrikums verursacht vor allem bei abnehmenden lateralen Größen einige Probleme. Um den Ladungsverlust bei abnehmendem Durchmesser in DRAM-Zellen zu vermeiden, wurde vorgeschlagen, den Graben tiefer zu ätzen oder die Dicke der Siliziumnitridschicht zu reduzieren. Das Ätzen eines tieferen Grabens würde jedoch nachteilhafterweise die Prozesszeit und die Kosten zur Herstellung erhöhen. Eine Reduktion der Schichtdicke des Siliziumnitridfilms kann eine Erhöhung des Verlusts durch den Tunneleffekt bewirken.

Eine Aufgabe der Erfindung ist es daher, ein Verfahren zur Erhöhung der Kapazität in einem Speichergraben und einen Grabenkondensator mit erhöhter Kapazität anzugeben, bei dem die Nachteile im Stand der Technik vermieden werden und bei dem trotz erhöhter Packungsdichte ausreichend Ladung gespeichert werden kann, so dass die Funktionalität einer Speicherzelle weiterhin gewährleistet ist.

Die Aufgabe wird durch ein Verfahren zur Erhöhung der Kapazität in einem Speichergraben gemäß Patentanspruch 1 und durch einen Grabenkondensator mit erhöhter Kapazität gemäß Patentanspruch 15 gelöst.

Vorteilhafte Weiterbildungen des erfindungsgemäßen Verfahrens und des erfindungsgemäßen Grabenkondensators ergeben sich aus den in den abhängigen Patentansprüchen angegebenen Merkmalen.

Beim erfindungsgemäßen Verfahren zur Erhöhung der Kapazität in einem Speichergraben wird im Speichergraben eine erste Schicht Siliziumoxid abgeschieden. Über der ersten Schicht Siliziumoxid wird eine Schicht Silizium mittels eines Abscheideverfahrens abgeschieden, das eine ausreichende Seitenwände des Speichergrabens liefert. Über der Schicht Silizium wird eine Schicht, die ein oxidiebares Metall aufweist, abgeschieden. Die Schicht Silizium und die Schicht oxidiebares Metall werden zu einer Schicht, die Metalloxid und Siliziumoxid aufweist, oxidiert.

Beim erfindungsgemäßen Grabenkondensator mit erhöhter Kapazität ist die Innenwand des Speichergrabens mit einer ersten Schicht Siliziumoxid bedeckt. Die erste Schicht Siliziumoxid ist mit einer Schicht, die Metalloxid aufweist, bedeckt. Die Schicht, die das Metalloxid aufweist, ist mit einer zweiten Schicht Siliziumoxid bedeckt. Der Rest des Speichergrabens ist mit Silizium gefüllt.

Als Abscheideverfahren kann vorteilhafterweise chemical vapor deposition oder atomic layer deposition eingesetzt werden.

Beim erfindungsgemäßen Verfahren ist es von Vorteil, wenn über der Schicht, die Metalloxid und Siliziumoxid aufweist, eine zweite Schicht Siliziumoxid abgeschieden wird.

Es ist auch von Vorteil, wenn die Schicht oxidierbares Metall Ti, TiN, W, WN, Ta, TaN, Wsi, TiSi oder TaSi aufweist.

Vorteilhafter Weise erfolgt die Oxidation in sauerstoffhaltiger Atmosphäre. Dadurch wird eine verstärkte Oxidation des jeweiligen Metalls erreicht.

Weiterhin ist es von Vorteil, den Speichergraben mit Silizium zu füllen.

Für das erfindungsgemäße Verfahren ist es von Vorteil, wenn der Speichergraben eine Breite von weniger als 140 nm aufweist.

Beim erfindungsgemäßen Verfahren ist es insbesondere bevorzugt, wenn die erste Schicht Siliziumoxid annähernd 0,3 nm dick ist.

Bei dem erfindungsgemäßen Verfahren ist es ebenfalls insbesondere bevorzugt, wenn die zweite Schicht Siliziumoxid annähernd 0,3 nm dick ist.

Weiterhin ist es bevorzugt, wenn die erste und die zweite Schicht Siliziumoxid mittels chemical vapor deposition abgeschieden werden.

Bei dem erfindungsgemäßen Verfahren ist es insbesondere bevorzugt, wenn die Schicht Silizium annähernd 0,5 nm dick ist.

Beim erfindungsgemäßen Verfahren ist es insbesondere bevorzugt, wenn das verwendete Silizium zur Bedeckung der Seitenwand besonders geeignet ist.

Es ist für das erfindungsgemäße Verfahren von Vorteil, dass die Schicht oxidierbares Metall annähernd 10 nm dick ist.

Weiterhin ist es für die erfindungsgemäßen Verfahren von Vorteil, wenn die Schicht, die das oxidierbare Metall aufweist, durch chemical vapor deposition abgeschieden wird.

Die Erfindung wird im folgenden an Hand mehrer Figuren näher erläutert.
- Figur 1: zeigt den Grabenkondensator im Querschnitt vor der Beschichtung.
- Figur 2: zeigt den Grabenkondensator im Querschnitt nach der Beschichtung mit der Siliziumoxid-, der Silizium- und der Metallschicht.
- Figur 3: zeigt den Grabenkondensator im Querschnitt nach Oxidation der Silizium- und der Metallschicht.
- Figur 4: zeigt den Grabenkondensator im Querschnitt mit zusätzlicher Siliziumoxidschicht.
- Figur 5: zeigt den Grabenkondensator im Querschnitt mit Siliziumfüllung.
- Figur 6: zeigt den Grabenkondensator im Querschnitt nach der Abätzung.
- Figur 7: zeigt in Form eines Struktogramms die einzelnen Prozessschritte des erfindungsgemäßen Verfahrens bei Verwendung von Wolfram.
- Figur 8: zeigt die einzelnen Prozessschritte des erfindungsgemäßen Verfahrens in Form eines Struktogramms bei Verwendung von Titan.

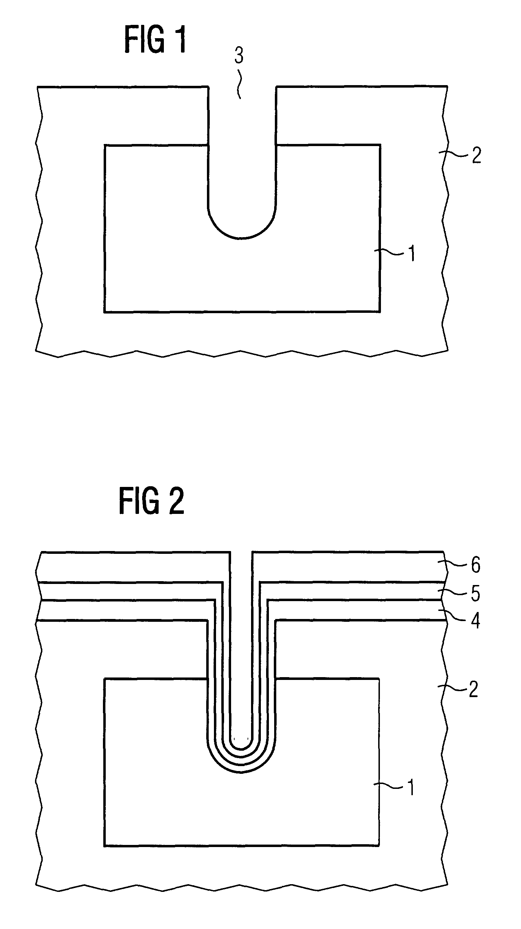

In Figur 1 ist - im Querschnitt dargestellt - eine vergrabene n-Zone 1 (buried n-plate) von einem Substrat 2 umgeben. In dem Substrat 2 und der vergrabenen n-Zone befindet sich ein Graben (Trench) 3.

In Figur 2 ist der Speichergraben 3 im Querschnitt gezeigt. Die Oberfläche des Substrats 2 sowie die Innenwand des Speichergrabens 3 sind mit einer ersten Schicht Siliziumoxid 4 beschichtet.

Das Siliziumoxid 4 weist an der Wandung des Grabens 3 eine geringere Schichtstärke als auf der Oberseite des Substrats 2 auf. Das Verhältnis der Schichtstärke auf der Oberseite des Substrats 2 zu den Seitenwänden des Grabens 3 kann bei 2:1 liegen. Die Siliziumoxidabscheidung auf der Oberseite des Substrats 2 beträgt annähernd 0,3 nm. Das Siliziumoxid 4 wird vorteilhafter Weise in einem Ofen, in dem sich der vorbereitete Grabenspeicher befindet, abgeschieden.

Die erste Schicht Siliziumoxid 4 wird in einem weiteren Prozessschritt mit einer Schicht Silizium 5 bedeckt. Auch bei der Schicht Silizium 5 ist die Schichtstärke im horizontalen Bereich höher als im vertikalen Bereich. Die Siliziumschicht 5 lässt sich am besten in einem Ofen bei 550 Grad Celsius mittels einer LPCVD (low pressure chemical vapor deposition)-Abscheidung erreichen.

Zur Abscheidung der Schicht Silizium 5 kann anstelle des CVD-Abscheideverfahrens auch das sogenannte atomic layer deposition (ALD)-Abscheideverfahren eingesetzt werden. Dabei handelt es sich um ein Abscheideverfahren zur Herstellung einer extrem dünnen, vorzugsweise lediglich einige Atomlagen dicken, Siliziumschicht. Beim ALD-Abscheideverfahren wird anders als beim CVD-Abscheideverfahren im wesentlichen die chemische Affinität der Oberfläche zu den einzelnen Molekülen oder Radikalen ausgenutzt. Diese lagern sich aus der Gasphase an der zu beschichtenden Oberfläche an, bis alle freien Valenzen gesättigt sind. Dadurch ist die Abscheidung selbstlimitierend und abgeschlossen.

Oberhalb der Schicht Silizium 5 wird eine Schicht 6, die ein oxidierbares Metall aufweist, abgeschieden. Wahlweise kann das Metall dieser Schicht 6 Ti, TiN, W, WN, Ta, TaN, Wsi, TiSi oder TaSi aufweisen. Diese Schicht 6 bedeckt die Siliziumschicht 5 sowohl im horizontalen als auch im vertikalen Bereich. Auch hier gilt, dass die Schichtstärke der Metallschicht 6 im horizontalen Bereich dicker als im vertikalen Bereich ist. Im horizontalen Bereich beträgt die Schichtstärke der Metallschicht 6 annähernd 10 nm. Die das Metall aufweisende Schicht 6 wird vorteilhafter Weise durch CVP (chemical vapor deposition) abgeschieden.

Die Schicht Silizium 5 dient als Benetzungsschicht für die Metallschicht 6. Dadurch wird die nachfolgende Metallabscheidung ermöglicht bzw. unterstützt und eine ausreichende Haftung des Metalls an den Seitenwänden gewährleistet. Durch die Siliziumschicht 5 wird zusätzlich die Kapazität der dielektrischen Schicht durch Oxidation der Metallschicht 6 im Trenchkondensator erhöht.

Im folgenden wird für die oxidierbare Metallschicht 6 beispielhaft Titan und Wolfram verwendet.

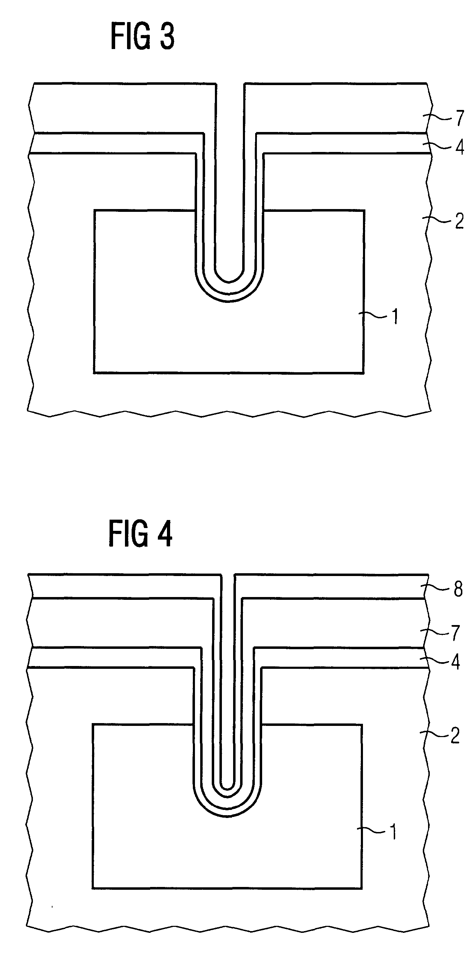

Nach erfolgter Oxidation der Siliziumschicht 5 und der Titan- oder Wolframschicht 6 ergibt sich ein wie in Figur 3 gezeigter Schichtaufbau des Grabenkondensators. Aus den beiden Schichten Silizium 5 und Titan- oder Wolfram 6 entsteht die Titanoxid/Titansiliziumoxidschicht bzw. Wolframoxid /Wolframsiliziumoxidschicht 7. Ob Titanoxid oder Titansiliziumoxid oder beides in der Schicht 7 entsteht, hängt von der Prozessführung ab. Es wird jedoch eine Prozessführung bevorzugt, bei der Titanoxid entsteht, da dieses eine höhere Dielektrizitätskonstante als Titansiliziumoxid aufweist. Das Entstehen von Siliziumoxid sollte durch eine geeignete Prozessführung vermieden werden.

Das gleiche gilt für das Entstehen von Wolframoxid oder Wolframsiliziumoxid. Auch hier wird Wolframoxid bevorzugt, da Wolframoxid eine höhere Dielektrizitätskonstante als Wolframsiliziumoxid aufweist. Dadurch ist eine Erhöhung der Speicherkapazität des Trenchkondensators möglich. Bei der Oxidation der Siliziumschicht 5 und der Titan- oder Wolframschicht 6 wächst die dadurch entstehende Schicht 7 durch den zusätzlich eingebauten Sauerstoff auf eine Schichtstärke von annähernd 15 nm im horizontalen Bereich an. Im vertikalen Bereich ist von einer Schichtstärke der Schicht 7 von ca. 10 bis 20 nm auszugehen. Dabei ist es Ziel, die Schicht 7 im vertikalen Bereich des Grabens 3 möglichst dick werden zu lassen.

Die Oberfläche der Titanoxid/Titansiliziumoxid-Schicht oder Wolframoxid/Wolframsiliziumoxid-Schicht 7 wird, wie in Figur 4 gezeigt, von einer zweiten Schicht Siliziumoxid oder Siliziumnitrid 8 bedeckt, wobei die zweite Schicht Siliziumoxid oder Siliziumnitrid 8 im vertikalen Bereich dünner als im horizontalen Bereich ist. Die horizontale Schichtstärke der zweiten Siliziumoxidschicht 8 beträgt annähernd 0,3 nm.

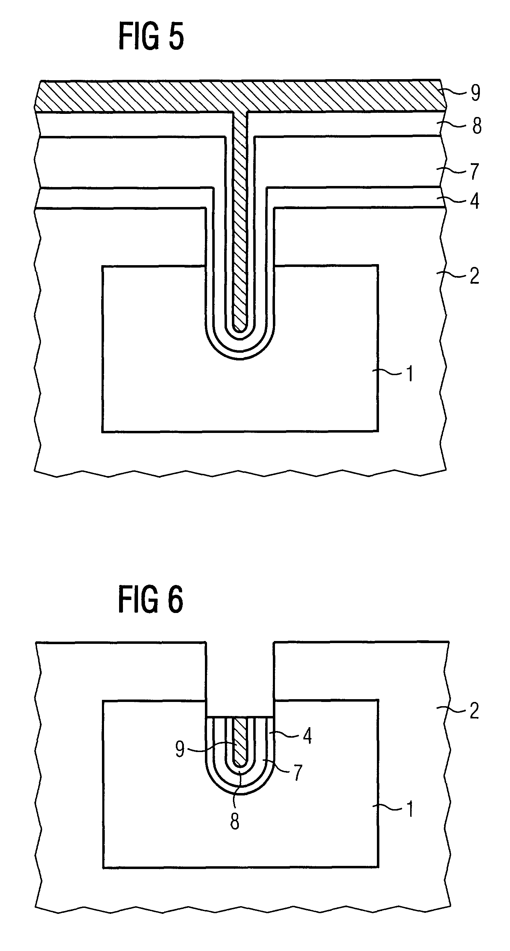

Wie in Figur 5 gezeigt, wird anschließend in einem weiteren Prozessschritt der Speichergraben 3 mit Silizium 9 gefüllt.

Schließlich wird in weiteren Prozessschritten der gesamte Schichtaufbau soweit wieder entfernt, dass sich ein wie in Figur 6 gezeigter Aufbau ergibt. Dies kann durch trockenchemisches Ätzen und anschließendes Nassreinigen erfolgen. Der Materialentfernungsvorgang wird unterhalb der Oberkante des buried plate Gebiets gestoppt.

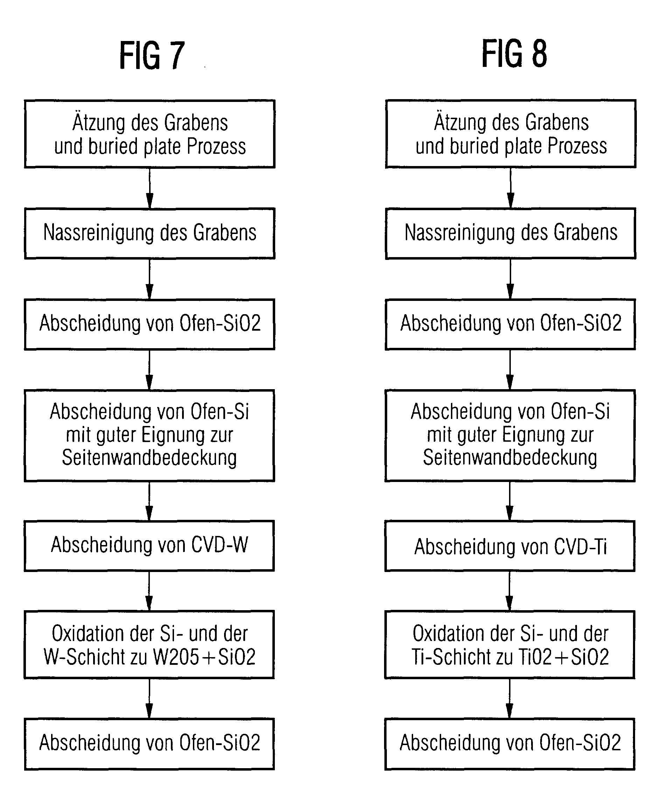

In Figur 7 ist in Form eines Strukturgramms das Herstellungsverfahren dargestellt. Nach der Ätzung des Grabens 3 und des buried plate Prozesses erfolgt eine Nassreinigung des Grabens 3. Anschließend wird Siliziumoxid 4 mit einer Schichtstärke von annähernd 0,3 nm (wie in Figur 2 gezeigt) abgeschieden. Das verwendete Siliziumoxid 4 wird auch als Ofen-Siliziumoxid bezeichnet. In einem weiteren Prozessschritt wird Ofen-Silizium 5, dessen Eigenschaft es ist, die Seitenwände des Grabens 3 gut zu bedecken, abgeschieden. Anschließend erfolgt eine Abscheidung von Wolfram 6 (Schichtstärke 10 nm) mittels chemical vapor deposition. Im nächsten Prozessschritt wird die Siliziumschicht 5 und die Wolframschicht 6 oxidiert, so dass Wolframoxid 7 entsteht. Schließlich erfolgt die Abscheidung einer zweiten Siliziumoxidschicht oder Siliziumnitrid 8 in einem Ofen.

In Figur 8 ist das Verfahren zur Erhöhung der Kapazität in einem Speichergraben unter Verwendung von Titan mittels eines Struktogramms angegeben. Wie vorher beschrieben, erfolgt zuerst die Ätzung des Grabens 3 und der buried plate Prozess.

Anschließend erfolgt die Nassreinigung des Grabens und in einem weiteren Schritt die Abscheidung von Ofen-Siliziumoxid. In einem weiteren Prozessschritt wird Ofen-Silizium in einem Ofen bei 550 Grad Celsius mittels low pressure chemical vapor deposition abgeschieden. Anschließend erfolgt die Abscheidung von Titan 6 (Schichtstärke 10 nm) durch chemical vapor deposition. Im nächsten Prozessschritt wird die Siliziumschicht 5 und die Titanschicht 6 zu einer Titanoxidschicht 7 oxidiert. Schließlich wird eine zweite Ofen-Siliziumoxidschicht oder Siliziumnitrid 8 darüber abgeschieden.

Der buried plate Prozess dient zur Isolierung des Trenchkondensators gegenüber dem für einen DRAM-Speicherbaustein notwendigen Transistor.

Die Siliziumschicht 5 unterstützt die Nukleation sowie die Haftung der gewünschten Metallschicht (Titan oder Wolfram) und lässt sich in Verbindung mit der nachfolgend abgeschiedenen Metallschicht 6 oxidieren.

Die oben angegebenen Schichtstärken stellen lediglich Richtwerte dar. Bei einer weiteren Verringerung der Grabenbreite sind die einzelnen Schichtstärken entsprechend anzupassen.

## Patentansprüche

1. Verfahren zur Erhöhung der Kapazität in einem Speichergraben,
bei dem im Speichergraben (3) eine erste Schicht Siliziumoxid (4) abgeschieden wird,
bei dem über der ersten Schicht Siliziumoxid (4) eine Schicht Silizium (5) mittels eines Abscheideverfahrens, das für eine ausreichende Bedeckung der Wand des Speichergrabens geeignet ist, abgeschieden wird,
bei dem über der Schicht Silizium (5) eine Schicht (6), die ein oxidierbares Metall aufweist, abgeschieden wird, bei dem die Schicht Silizium (5) und die Schicht (6), die das oxidierbare Metall aufweist, zu einer Schicht, die Metalloxid und Siliziumoxid (7) aufweist, oxidiert werden.

2. Verfahren nach Patentanspruch 1,
bei dem als Abscheideverfahren chemical vapor deposition oder atomic layer deposition eingesetzt wird.

3. Verfahren zur Erhöhung der Kapazität in einem Speichergraben nach Patentanspruch 2,
bei dem über der Schicht (6), die das oxidierbare Metall aufweist, und Siliziumoxid (7) eine zweite Schicht Siliziumoxid oder Siliziumnitrid (8) abgeschieden wird.

4. Verfahren nach einem der Patentansprüche 1, 2 oder 3,
bei dem die Schicht (6), die das oxidierbare Metall aufweist, Ti, TiN, W, WN, Ta, TaN, Wsi, TiSi oder TaSi aufweist.

5. Verfahren nach einem der Patentansprüche 1 bis 4,
bei dem die Oxidation in sauerstoffhaltiger Atmosphäre durchgeführt wird.

6. Verfahren nach einem der Patentansprüche 1 bis 5,
bei dem der Speichergraben (3) mit Silizium (9) gefüllt wird.

7. Verfahren nach einem der Patentansprüche 1 bis 6,
bei dem der Speichergraben (3) weniger als 140 nm breit ist.

8. Verfahren nach einem der Patentansprüche 1 bis 7,
bei dem die erste Schicht Siliziumoxid (4) annähernd 0,3 nm dick ist.

9. Verfahren nach einem der Patentansprüche 1 bis 8,
bei dem die zweite Schicht Siliziumoxid (8) annähernd 0,3 nm dick ist.

10. Verfahren nach einem der Patentansprüche 1 bis 9,
bei dem die erste und die zweite Schicht Siliziumoxid (4,8) mittels chemical vapor deposition abgeschieden werden.

11. Verfahren nach einem der Patentansprüche 1 bis 10,
bei dem die Schicht Silizium (5) annähernd 0,5 nm dick ist.

12. Verfahren nach einem der Patentansprüche 1 bis 11,
bei dem das für die Schicht Silizium (5) verwendete Silizium eine besondere Eignung zur Bedeckung der Seitenwand des Grabens (3) aufweist.

13. Verfahren nach einem der Patentansprüche 1 bis 12,
bei dem die Schicht (6), die das oxidierbare Metall aufweist, annähernd 10 nm dick ist.

14. Verfahren nach einem der Patentansprüche 1 bis 13,
bei dem die Schicht (6), die das oxidierbare Metall aufweist, durch chemical vapor deposition abgeschieden wird.

15. Grabenkondensator mit erhöhter Kapazität,
bei dem die Innenwand des Speichergrabens (3) mit einer ersten Schicht Siliziumoxid (4) bedeckt ist,
bei der die erste Schicht Siliziumoxid (4) mit einer Schicht, die Metalloxid (7) aufweist, bedeckt ist,
bei der die Schicht, die Titanoxid (7) aufweist, mit einer zweiten Schicht Siliziumoxid (8) bedeckt ist,
bei der der Rest des Speichergrabens (3) mit Silizium (9) gefüllt ist.

16. Grabenkondensator mit erhöhter Kapazität nach Patentanspruch 15,
bei dem das Metalloxid Ti, TiN, W, WN, Ta, TaN, Wsi, TiSi oder TaSi aufweist.
